# EUROPEAN PATENT APPLICATION

(11) **EP 4 770 384 A1**
(43) Date of publication of application: **01.07.2026**
(21) Application number: 25227182.0
(22) Date of filing: 24.12.2025
(51) Int. Cl.: H10K 59/131, G02F 1/1345

(54) **DISPLAY PANEL**

(30) Priority: 30.12.2024 KR 20240199898
(71) Applicant: LG Display Co., Ltd., Seoul, 07336 (KR)
(72) Inventor: NAM, Won Il, 10845 Paju-si (KR); JANG, Gyu Bum, 10845 Paju-si (KR); YU, Myeong Hyeon, 10845 Paju-si (KR); LEE, Hyun Haeng, 10845 Paju-si (KR); JEON, Seung Joon, 10845 Paju-si (KR); CHOI, Ki Min, 10845 Paju-si (KR); KIM, Ju Hyuk, 10845 Paju-si (KR); KIM, Yong Hyeon, 10845 Paju-si (KR); SONG, Min Gyu, 10845 Paju-si (KR)
(74) Representative: Ter Meer Steinmeister & Partner

(57) **Abstract**

A display panel includes a circuit film disposed on one side of a substrate, a plurality of first link parts connected to the circuit film, a first bar having first bridges respectively connected to the plurality of first link parts. The first bar has a plane extending in a length direction and a width direction. Each first bridge has a width in the length direction, and the first bridges located at on opposite sides of the first bar in the length direction have a width greater than that of the first bridge located at a center of the first bar in the length direction. This configuration facilitates distribution of current supplied through the first link parts and supports stable electrical connection between the circuit film and the first bar.

## Description

This application claims priority of KR Patent Appl. No. 10-2024-0199898, filed 30.12. 2024.

### BACKGROUND

### Technical Field

The disclosure relates to a display panel, and more particularly to a display panel that minimizes heat generation in a pad part and prevents short circuits due to electrolytic corrosion.

### Description of Related Art

With the advent of full-fledged information age, the field of display devices that visually represent electrical information signals is developing rapidly.

Representative examples of display devices may include liquid crystal display apparatuses (LCD), organic light-emitting display apparatuses (OLED), and quantum dot display apparatuses.

The display panel of the display device may include a pad part to which a driving voltage or common voltage is applied. A plurality of circuit films may be disposed on the pad part. A link part to which the driving voltage or common voltage is applied may be electrically connected to each circuit film.

### BRIEF SUMMARY

In the related art, the link part of the display panel, in which numerous link wires are integrated within a limited space of the circuit film, may experience an increase in current density. This increased current density can lead to heat generation in the pad part.

Additionally, among the numerous link wires, those exposed to the outside of the circuit film may be susceptible to electrolytic corrosion in high-humidity environments. When such corrosion occurs, short circuits may form between link wires, particularly where there are significant potential differences.

It is an object to provide a display panel which is designed to reduce heat caused by the integration of link wires supplying the pixel driving voltage in a limited space and to prevent short circuits due to electrolytic corrosion.

Technical benefits according to embodiments of the disclosure are not limited to the above-described benefits, and other benefits that are not described herein will be apparently understood by those skilled in the art from the following description.

The object is solved by the features of the independent claims. Preferred embodiments are given in the dependent claims.

In one aspect a display panel according to an embodiment of the disclosure may include a circuit film disposed on one side of a substrate, a plurality of first link parts connected to the circuit film, and a first bar including a plurality of first bridges respectively connected to the plurality of first link parts, wherein the first bar has a plane extending in a length direction and a width direction. The first bridges each have a width in the length direction, and the first bridges disposed on the sides of the first bar in the length direction have a wider width than the first bridge at the center of the first bar in the length direction.

In another aspect, a display panel is provided comprising a circuit film; dummy link parts electrically connected to the circuit film, each including dummy pins connected to an external circuit located outside the circuit film; a plurality of first link parts electrically connected to the circuit film and disposed between the dummy link parts; a plurality of second link parts disposed between the dummy link parts and the first link parts; and a first bar connected to the dummy link parts and the first link parts, wherein the first bar includes: a plurality of first bridges arranged at intervals along the first direction, each having a width in a first direction and connected to a respective one of the plurality of first link parts; and second bridges respectively connected to the dummy link parts, and wherein the widths of the plurality of first bridges increase from a center of the first bar to opposite sides of the first bar in the first direction, and a minimum distance between the dummy pins and the second link part closest to the respective dummy link part is greater than a distance between adjacent second link parts.

In another aspect a display panel is provided comprising a circuit film; dummy link parts electrically connected to the circuit film; a plurality of first link parts disposed between the dummy link parts; and a first bar connected to the dummy link parts, wherein each of the dummy link parts includes: dummy pins connected to external circuit disposed outside the circuit film; a minimum distance between the dummy pins and the first link part closest to the respective dummy link part is a first distance; there is a second distance between adjacent first link parts; and the first distance is greater than the second distance.

In another aspect a display device is provided comprising a display panel as described in anyo one of the preceding aspects.

In another aspect a display panel is provided comprising: a circuit film; a plurality of first link parts electrically connected to the circuit film; and a first bar having a length in a first direction and a width in a second direction transverse to the first direction, the plurality of first link parts connected to the first bar, wherein the first bar has either a width that is greater at a center than at opposite sides thereof in the first direction, or a width that is greater at the opposite sides than at the center in the first direction.

In the following optional features are provided, which can be combined alone, in combination or in sub-combination with the above mentioned general idea.

In one or more embodiments, the first link parts may be supplied with a driving voltage from the circuit film.

In one or more embodiments, the display panel may comprise dummy link parts connected respectively to the sides of the first bar in the first direction; and a plurality of second link parts disposed between the dummy link parts.

In one or more embodiments, each of the dummy link parts may include dummy pins connected to an external circuit disposed outside the circuit film.

In one or more embodiments, a minimum distance between the dummy pins and the second link part that is closest to the respective dummy link part may be a first distance, there is a second distance between adjacent second link parts, and the first distance may be greater than the second distance.

In one or more embodiments, each of the dummy link parts may include dummy pads connected to the first bar on one end and connected to the dummy pins on the other end.

In one or more embodiments, each of the dummy pads may include a plurality of dummy link wires.

In one or more embodiments, the dummy pins may be connected to some of the dummy link wires.

In one or more embodiments, the first bar may include second bridges, on each of the sides in the first direction, connected to one side of a respective dummy pad.

In one or more embodiments, each of the second bridges may have a wider width than each of the first bridges.

In one or more embodiments, the dummy link parts may be supplied with a driving voltage from the external circuit of the circuit film, the second link parts may be supplied with a reference voltage or a data voltage from the external circuit of the circuit film.

In one or more embodiments, the first bar may include a bar pattern.

In one or more embodiments, the first bridges projecting from the bar pattern in a second direction may transverse to the first direction.

In one or more embodiments, the bar pattern may include a first side disposed in the first direction; second sides bent at both ends of the first side; third sides bent from the second sides; and fourth sides respectively connected to the third sides.

In one or more embodiments, the distance between the third sides and the first side may increase from the sides toward the center in the first direction.

In one or more embodiments, the display panel may comprise a plurality of second link parts disposed between the first link parts.

In one or more embodiments, each of the second link parts may include connection portions spaced apart from each of the third and the fourth sides of the first bar in the second direction transverse to the first direction; and a second-first link wire and a second-second link wire connected via the connection portions.

In one or more embodiments, the connection portions may form unit regions between the first link parts.

In one or more embodiments, the connection portions disposed in the unit regions may be arranged side-by-side in the first direction.

In one or more embodiments, the unit regions disposed between the first link parts may be arranged in a stepped configuration along the third and the fourth sides of the first bar.

In one or more embodiments, the unit regions disposed between the first link parts may include a different number of connection portions.

In one or more embodiments, the second-second link wire may include a zigzag region that bends by changing direction based on turning points.

In one or more embodiments, the number of zigzag regions included in the unit regions may increase from the sides toward the center in the first direction.

In one or more embodiments, the second-second link wire may include a zigzag region that bends by changing direction based on turning points.

In one or more embodiments, the number of turning points included in the zigzag regions in each of the unit regions may increase from the sides toward the center in the first direction.

In one or more embodiments, the first bar may have a width in a second direction transverse to the first direction.

In one or more embodiments, the first bar may have a width that increases from the center toward the sides in the first direction.

In one or more embodiments, the first bar may have a plane extending in the first direction and a second direction transverse to the first direction, and a cross-section in a third direction perpendicular to the plane.

In one or more embodiments, the display panel may comprise a plurality of second link parts disposed between the first link parts and having an overlapping region overlapping with the first bar in the third direction.

In one or more embodiments, the display panel may comprise a semiconductor pattern disposed in the overlapping region and between the first bar and the second link parts.

In one or more embodiments, the first bar may include a bar pattern and second bridges, wherein the bar pattern, the first bridges, and the second bridges may be integrally formed.

In one or more embodiments, the dummy link parts may be supplied with a driving voltage from the external circuit of the circuit film, and the first link parts may be supplied with a reference voltage or a data voltage from the external circuit of the circuit film.

In one or more embodiments, each of the dummy link parts may include dummy pads connected to the first bar on one end and connected to the dummy pins on the other end, each of the dummy pads may include a plurality of dummy link wires, and the dummy pins may be connected to some of the plurality of dummy link wires.

In one or more embodiments, the first bar may have a plane extending in a first direction, and a second direction transverse to the first direction.

In one or more embodiments, the display panel may comprise a plurality of second link parts disposed between the dummy link parts and connected to the first bar.

In one or more embodiments, the first bar may include first bridges projecting in the second direction and respectively connected to the second link parts; and second bridges projecting in the second direction and respectively connected to the dummy link parts.

In one or more embodiments, each of the first and the second bridges may have a width in the first direction, each of the second bridges may have a wider width than each of the first bridges.

In one or more embodiments, the widths of the first bridges may increase from a center of the first bar toward opposite sides of the first bar in the first direction.

In one or more embodiments, the first bar may include a bar pattern, first bridges, and second bridges which are integrally formed.

In one or more embodiments, the dummy link parts may be supplied with a driving voltage from the external circuit of the circuit film, and the second link parts are supplied with a reference voltage or a data voltage from the external circuit of the circuit film.

In one or more embodiments, each of the dummy link parts may include dummy pads connected to the first bar on one end and connected to the dummy pins on the other end, each of the dummy pads may include a plurality of dummy link wires, and the dummy pins may be connected to some of the plurality of dummy link wires.

In one or more embodiments, the first bar may include a bar pattern, wherein the bar pattern, the first bridges, and the second bridges may be integrally formed.

In one or more embodiments, the first bar may include a plurality of first bridges arranged at intervals along the first direction, each having a width in the first direction and connected to a respective one of the plurality of first link parts, and the widths of the plurality of first bridges may increase from the center of the first bar toward the sides of the first bar in the first direction.

In one or more embodiments, the display panel may comprise dummy link parts electrically connected to the circuit film and connected to the first bar, each including dummy pins connected to an external circuit located outside the circuit film; and a plurality of second link parts disposed between the dummy link parts and the first link parts.

In one or more embodiments, a minimum distance between the dummy pins and the second link part closest to the respective dummy link part may be greater than a distance between adjacent second link parts.

A display panel according to an embodiment of the disclosure may have the effect of minimizing heat generation in a pad part.

A display panel according to an embodiment of the disclosure may have the effect of preventing short circuits between link wires due to electrolytic corrosion.

The effects of the disclosure are not limited to the effects mentioned above, and other effects not mentioned can be clearly understood by those skilled in the art to which the technical idea of the disclosure pertains from the following description.

### BRIEF DESCRIPTION OF THE SEVERAL VIEWS OF THE DRAWINGS

The above and other objects, features, and advantages of the disclosure will become more apparent to those of ordinary skill in the art by describing exemplary embodiments thereof in detail with reference to the attached drawings, in which:
FIG. 1 is a schematic plan view of a display panel of an embodiment of the disclosure.
FIG. 2 is a circuit diagram for a sub-pixel circuit according to an embodiment.
FIG. 3A is a diagram illustrating the shape of a first bar BA1 according to an embodiment.
FIG. 3B is a diagram illustrating another shape of the first bar BA1, according to an embodiment.
FIG. 4 is an enlarged plan view of an area A in FIG. 1.
FIG. 5 is an enlarged plan view of an area B in FIG. 4.
FIG. 6A is a view illustrating connection portion of a second link part of an embodiment.
FIG. 6B is a cross-sectional view along the line I-I' of FIG. 6A.
FIG. 7 is an enlarged plan view of an area E in FIG. 6A.
FIG. 8 is a diagram illustrating the first bar BA1 according to an embodiment.
FIGS. 9A and 9B are diagrams illustrating semiconductor patterns corresponding to the shape of the first bar according to various embodiments.
FIG. 10 is a cross-sectional view along the line I-I' of FIG. 6B including the semiconductor pattern.
FIG. 11 is a schematic plan view of a display panel to which embodiments of the disclosure are applied.

### DETAILED DESCRIPTION

Advantages and features of the disclosure and methods of achieving them will become apparent with reference to the following embodiments, which are described in detail, in conjunction with the accompanying drawings. However, the disclosure is not limited to the embodiments to be described below and may be implemented in various different forms, and the embodiments are only provided to completely disclose the disclosure and completely convey the scope of the disclosure to those skilled in the art.

The shapes, sizes, dimensions (e.g., length, width, height, thickness, radius, diameter, area, etc.), ratios, angles, number of elements, and the like illustrated in the accompanying drawings for describing the embodiments of the disclosure are merely examples, and the disclosure is not limited thereto.

A dimension including size and a thickness of each component illustrated in the drawing are illustrated for convenience of description, and the disclosure is not limited to the size and the thickness of the component illustrated, but it is to be noted that the relative dimensions including the relative size, location, and thickness of the components illustrated in various drawings submitted herewith are part of the disclosure.

The same reference number indicates the same components throughout the disclosure. Further, in describing the disclosure, when it is determined that a detailed description of related known technology may unnecessarily obscure the gist of the disclosure, the detailed description thereof will be omitted. When "providing," "including," "having," "consisting of," and the like mentioned in the disclosure are used, other parts may be added unless 'only' is used. A case in which a component is expressed in a singular form may include a plural form unless explicitly stated otherwise.

In a description of a positional relationship, when the positional relationship of two parts such as "on," "at an upper portion," "at a lower portion," "next to," "adjacent to," or the like is described, one or more other parts may be located between two components unless "immediately", "directly," "close to" is used.

a description of a temporal relationship, when the temporal relationship is described as "after," "following," "then," "before," or the like, non-consecutive cases may also be included unless "immediately" or "directly" is used.

Although first, second, and the like are used to describe various components, these components are not limited by these terms. These terms are only used to distinguish one component from another component. Accordingly, a first component described below may also be a second component within the technical concept of the disclosure.

The terms, such as first, second, A, B, (a), and (b) may be used to describe components of the disclosure. These terms are only for the purpose of distinguishing one component from another component, and the nature, sequence, order, or the like of the corresponding components is not limited by these terms.

When a component is described as being "connected," "coupled," "linked," or "attached" to another component, it should be understood that the component may be directly connected, coupled, linked, or attached to the other component, but another component may be interposed between the components which may be connected, coupled, linked, or attached to each other unless explicitly stated otherwise.

When a component or layer is described as "in contact with" or "overlap" another component or layer, it should be understood that the component or layer may be in direct contact with or directly overlap another component or layer, but another component may be interposed between the components which may be in contact with or overlap each other unless explicitly stated otherwise.

To further elaborate, as used herein, the term "connected" is intended to have the broadest possible meaning. Specifically, the phrase "A is connected to B" encompasses both a direct connection-where no intervening components or elements are-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The terms "coupled" and "in contact" should be interpreted in the same manner.

"At least one" should be understood as including a combination of one or more of the related components. For example, the term "at least one of first, second, and third components" includes not only the first, second, or third component, but also all combinations of two or more of the first, second, and third components.

The terms "a first direction," "a second direction," "a third direction," "an X-axis direction," "a Y-axis direction," and "a Z-axis direction" should not be understood as only a geometric relationship where a relationships therebetween are perpendicular to each other, but mean that a configuration of the disclosure has a broader directionality within a range which may functionally acts.

Features of various embodiments of the disclosure may be partially or entirely combined with each other, and technically, various linkages and operations are possible, and the embodiments may be implemented independently of each other or together in a related relationship. The scale of components shown in the drawings is not limited to the scale depicted in the drawings, as it may differ from the actual scale for the sake of clarity.

The disclosed display panel addresses heat concentration, electrolytic corrosion, and/or wiring reliability issues in the pad region through a set of coordinated structural features.

To reduce heat, the panel includes a first bar whose width varies along the horizontal direction, with versions that are wider at the center or wider at the outer sides.

The first bridges that connect to the first link parts may also vary in width, preferably increasing toward the outer sides to improve current distribution.

The bar pattern, first bridges, and second bridges may be formed as a single continuous structure to enhance electrical and thermal performance.

To reduce the risk of corrosion related short circuits, the design incorporates dummy link parts that receive a high potential driving voltage and are spaced from the nearest second link parts by a defined minimum distance that is greater than the spacing between adjacent second link parts. Dummy pins connect only to selected dummy link wires within the dummy pads so that conductors at different potentials maintain sufficient physical separation. The second bridges that connect to the dummy link parts are formed with larger widths than the first bridges in order to support higher current flow and improve stability in environments susceptible to corrosion.

Wiring reliability is further achieved through stepped regions that contain the connection portions of the second link parts and are arranged to avoid overlap with the first bar, and through second-second link wires that incorporate zigzag segments with more direction changes toward the center. This arrangement balances signal path lengths by compensating for geometric variations introduced by the shaped first bar. A semiconductor pattern is also positioned between overlapping metal layers of the first bar and the second link parts to reduce the likelihood of vertical short circuits. Collectively, these structural arrangements improve thermal behavior, corrosion resistance, and signal uniformity in the display panel.

Now the various embodiments of the disclosure will be explained in detail in connection with the drawings.

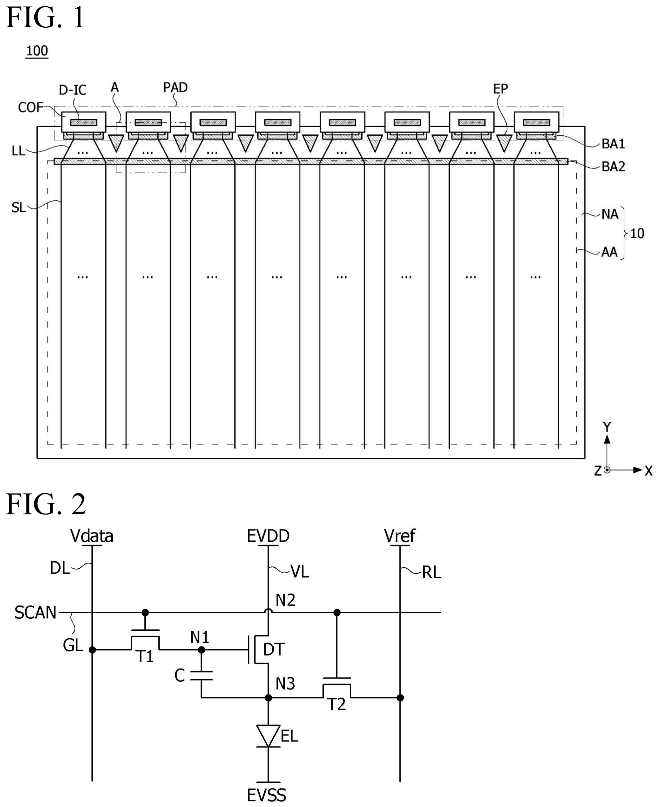

FIG. 1 is a schematic plan view of a display panel of an embodiment of the disclosure.

Referring to FIG. 1, a horizontal direction X and a vertical direction Y of a display panel 100 may be a length direction and a width direction of the display panel 100, respectively. The horizontal direction X and the vertical direction Y of the display panel 100 may also be represented as a first direction and a second direction, respectively. Further, the horizontal direction X and the vertical direction Y of the display panel 100 may also be represented by a row direction and a column direction, respectively. A thickness direction Z may refer to a direction perpendicular to a plane defined by the horizontal direction X and the vertical direction Y of the display panel 100. The thickness direction Z may also be represented by a third direction. The display panel 100 may have a cross-section in the thickness direction Z.

Referring to FIG. 1, the display panel 100 of an embodiment of the disclosure may include a substrate 10, and a circuit film COF (also referred to as circuit-on-film) disposed on one side of the substrate 10 and a first bar BA1 connected to the circuit film COF. The COF may at least partly overlap the substrate 10.

The display panel 100 may implement the display of information, video, and/or images provided for the user. For example, the display panel 100 may include a display area AA and a non-display area NA. Accordingly, for example, the substrate 10 may include the display area AA and the non-display area NA. The non-display area NA may be adjacent to the display area AA or may surround the display area AA fully or at least partly.

The substrate 10 may be made of an insulating material. For example, the substrate 10 may be made of glass or resin. The substrate 10 may also be made of a material having flexibility. For example, the substrate 10 may be made of a plastic material having flexibility, such as polyimide (PI). However, embodiments of the disclosure are not limited thereto.

The display area AA may be an area where an image is displayed. The display area AA of the substrate 10 or the display panel 100 may be configured in a variety of shapes depending on the design of the display device. For example, the display area AA may be configured as a rectangular shape with four rounded corners, but embodiments of the disclosure are not limited thereto. For another example, the display area AA may be configured as a rectangular shape with four right-angled corners, a circular shape, or the like, but embodiments of the disclosure are not limited thereto.

The display area AA may include a plurality of pixels. Each of a plurality of pixels may be composed of a plurality of sub-pixels. The plurality of pixels may be arranged in a matrix, forming a plurality of rows and a plurality of columns, but embodiments of the disclosure are not limited thereto.

The display area AA may include signal wires SL that are connected to link wires LL in the non-display area NA.

The non-display area NA may be an area where no image is displayed. Various wires and/or one or more circuits (including a pad part PAD) for driving a plurality of pixels in the display area AA may be arranged in the non-display area NA. The pad part PAD of an embodiment of the disclosure may include a plurality of circuit films COF, and a first bar BA1 individually connected to each of the plurality of circuit films COF.

The plurality of circuit films COF may be spaced apart from each other in X direction and disposed on one side of the substrate 10. Each of the plurality of circuit films COF may have a length in the horizontal direction X and a width in the vertical direction Y. In the following description, the length direction and width direction of each circuit film COF are defined as the X-direction and Y-direction, respectively. For example, a plurality of circuit films COF may have a length in the horizontal direction X that is longer than a width in the vertical direction Y. However, the shape of the plurality of circuit films COF described herein of an embodiment is not limited.

Each of the plurality of circuit films COF may include one or more drive ICs (D-IC). The number of circuit films COF may vary depending on the number of different wires connected to them. For example, the number of the plurality of circuit films COF may be further reduced for a display panel driven by double rate driving (DRD) than for a display panel driven by 1 gate 1 data (1G1D). However, the number of the plurality of circuit films COF is not limited to that shown.

The first bars BA1 may be individually connected to each of a plurality of circuit films COF. The first bar BA1 of an embodiment may have a length in the horizontal direction X. The lengths of the first bar BA1 may be shorter than the length of COF.

The first bar BA1 may be connected to any one of various types of signal wires located in the non-display area NA. For example, the first bar BA1 may be connected to driving voltage lines supplying a driving voltage. However, an embodiment of the disclosure is not limited thereto.

In the non-display area NA, the link wires LL and/or electrode patterns EP may be arranged to transmit signals to the display area AA. For example, the link wires LL may include driving voltage lines for supplying a driving voltage, reference voltage lines for supplying a reference voltage, and data lines for supplying a data signal. For example, the electrode patterns EP may be for supplying a common voltage. The signals and/or the voltages may be supplied from outside the display panel to the link lines LL and/or electrode patterns EP.

However, the components in the non-display area NA of an embodiment are not limited to those shown. For example, various wires and driving circuits may be mounted in the non-display area NA, and printed circuits and the like may be connected to the pad part PAD.

For example, the driving circuits may be a data driving circuit and/or a gate driving circuit, but embodiments of the disclosure are not limited thereto. Wires to which control signals for controlling the driving circuits are supplied may be arranged. For example, the control signals may include various timing signals including at least one of a clock signal, input data enable signal, and synchronization signal, but embodiments of the disclosure are not limited thereto. The control signal may be received through the pad part.

Meanwhile, a second bar BA2 shown in FIG. 1 may be arranged in the display area AA. The second bar BA2 may be connected to the signal wires that are connected to the first bar BA1. For example, if the first bar BA1 is connected to the driving voltage lines, the second bar BA2 may also be connected to the driving voltage lines. In this case, the second bar BA2 may be one of driving voltage lines in a mesh pattern in which a first driving voltage line and a second driving voltage line cross each other and are repeatedly arranged in the display area AA.

However, the second bar BA2 in an embodiment of the disclosure is not limited thereto, and may be a bar arranged in a single form rather than some of the driving voltage lines that are repeatedly arranged.

Further, the location of the second bar BA2 is not limited to that shown, and may be arranged in the non-display area NA rather than the display area AA.

The second bar BA2 may extend in the same direction as the plurality of first bars. The length of the second bar BA2 is longer than the single and/or combined lengths of he first bars BA1.

FIG. 2 is a circuit diagram for a sub-pixel circuit of an embodiment.

Referring to FIG. 2, a circuit for each of sub-pixels (PXL) (hereinafter referred to as a sub-pixel circuit) may be connected to a data line DL to which a data voltage Vdata of pixel data is applied, a gate line GL to which a gate pulse SCAN is applied, a driving voltage line VL to which a pixel driving voltage EVDD is applied, a low potential voltage line to which a low potential voltage EVSS is applied, and a reference voltage line RL to which a reference voltage Vref is applied.

Each sub-pixel circuit may include a light-emitting element EL, a plurality of transistors DT, T1, and T2, and a capacitor C. However, in the display panel described herein, the sub-pixel circuit configuration is not limited thereto.

The light-emitting element EL may be an organic light-emitting diode (OLED) or an inorganic light-emitting element such as micro LED. The light-emitting element EL may include, but not limited to, a red light-emitting element, a green light-emitting element, and a blue light-emitting element. An anode electrode of the light-emitting element EL may be electrically connected to transistor DT acting as a driving element (hereinafter referred to as driving element DT) and disposed in the corresponding light-emitting area in each pixel. The light-emitting element EL is driven and emits light when a current from the driving element DT is generated, and the light is emitted to the outside of the display panel through the light-emitting area.

The driving element DT may generate a current according to the gate-source voltage to drive the light-emitting element EL. The driving element DT includes a gate electrode connected to a first node N1, a first electrode connected to a second node N2, and a second electrode connected to a third node N3. A capacitor C is connected between the first node N1 and the third node N3. The second node N2 is connected to the driving voltage line VL. The third node N3 is connected to an anode electrode of the light-emitting element EL. A cathode electrode of the light-emitting element EL is connected to a low-potential voltage line to which the low potential voltage EVSS is applied.

The transistor T1 acting as a first switch element (hereinafter referred to as first switch element T1) is connected between the data line DL and the first node N1. The first switch element T1 is turned on in response to the gate pulse SCAN. When the first switch element T1 is turned on, the data voltage Vdata of the pixel data is applied to the first node N1, thereby writing the pixel data to the sub-pixel. The first switch element T1 may include a gate electrode connected to the gate line GL, a first electrode connected to the data line DL, and a second electrode connected to the first node N1.

The transistor T2 acting as a second switch element (hereinafter referred to as second switch element T2) is connected between the third node N3 and the reference voltage line RL. The second switch element T2 is turned on in response to the gate pulse SCAN. When the second switch element T2 is turned on, the third node N3 is connected to the reference voltage line RL. The second switch element T2 may include a gate electrode connected to the gate line GL, a first electrode connected to the third node N3, and a second electrode connected to the reference voltage line RL.

The driving element DT should have uniform electrical characteristics across all sub-pixels; however, due to process deviations and device characteristic deviations, differences in electrical characteristics may exist between sub-pixels, and these differences may increase as the sub-pixel driving time elapses. To compensate for these deviations in the electrical characteristics of the driving element DT, an external compensation circuit may be applied to the display panel driving circuit.

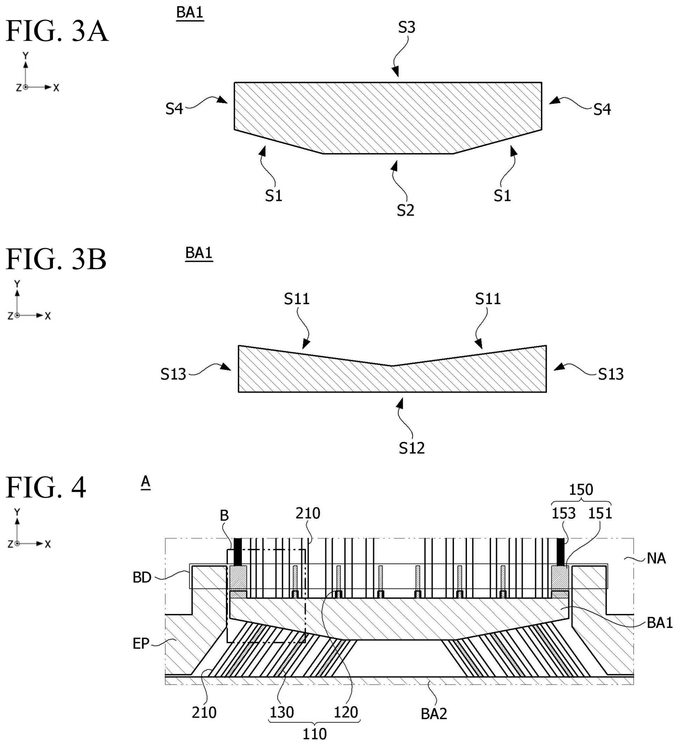

FIG. 3A is a diagram illustrating the shape of a first bar BA1 of an embodiment.

Referring to FIG. 3A, the first bar BA1 of an embodiment may be formed in a shape that maximizes area within a limited space. The first bar BA1 of an embodiment may have a wider width (in the vertical direction Y) at its center than at opposite sides in the horizontal direction X. The shape of the first bar BA1 may reduce the heat concentrated in the center of the first bar BA1 in the horizontal direction X.

For example, the first bar BA1 in an embodiment may include first to fourth sides S1, S2, S3, and S4 bent relative to each other. Specifically, the third side S3 is disposed along the horizontal direction X and may be an end adjacent to the circuit film COF. Here, bridges may be further formed on the third side S3. The fourth sides S4 may be ends bent respectively at each of both ends of the third side S3. For example, the fourth sides S4 may be substantially perpendicular to the third side S3. The fourth side may be parallel or substantial parallel to the shorter sides of the display panel.

The first side S1 is bent from each fourth side S4, forming an interior angle greater than 90° with the fourth side S4. As shown in FIG. 3A, the first side S1 may be configured to extend from the fourth side S4 in a manner away from the third side S3. In other words, the distance between the first sides S1 and the third side S3 may increase from the sides toward the center in the horizontal direction X. The second side S2 may be configured to connect each of the first sides S1. The angles between the left and right side (fourth side) of the first bar BA1 and the first sides might be similar or different, but greater than 90°. The second side S2 may be parallel to the third side and extend in parallel to the long side of the display panel. The second side S2 may be be not directly connected to the fourth sides S4 but may have a right angle to the the fourth sides S4.

FIG. 3B is a diagram illustrating another shape of the first bar BA1, of an embodiment.

Referring to FIG. 3B, another shape of the first bar BA1 of an embodiment may have a wider width (in the vertical direction Y) at its both sides compared to its center along the horizontal direction X. In other words, another shape of the first bar BA1 in this embodiment may widen from the center toward both sides. The first bar BA1 having the forgoing shape may distribute heat concentrated at its center toward its both sides.

For example, another shape of the first bar BA1 in an embodiment may include eleventh to thirteenth sides S11, S12, and S13 bent relative to each other. Specifically, the eleventh side S11 may be disposed at each of the both sides relative to the center along the horizontal direction X. In this case, each of the eleventh sides S11 is connected at the center, and may be formed to approach the circuit film COF as it moves from the center toward both sides. In other words, the two eleventh sides S11 may be bent relative to each other. Additionally, bridges may be formed on the eleventh side S11.

The thirteenth side S13 may be an end bent from each end of the eleventh side S11. The twelfth side S12 may be configured to connect the thirteenth sides S13. In this configuration, the twelfth sides S12 may be formed in a nearly straight shape to allow the first bar BA1 to have a wider width (in the vertical direction Y) from the center toward both sides along the horizontal direction X.

In the following, in most embodiments, the shape of the first bar BA1 shown in FIG. 3A will be described as a representative. However, embodiments of the disclosure are not limited to the shape of the first bar BA1 shown in FIG. 3A, and the first bar BA1 having various shapes may be applied to each embodiment.

By having different widths of the first bar BA1 over its horizontal extension, the heat distribution can be improved.

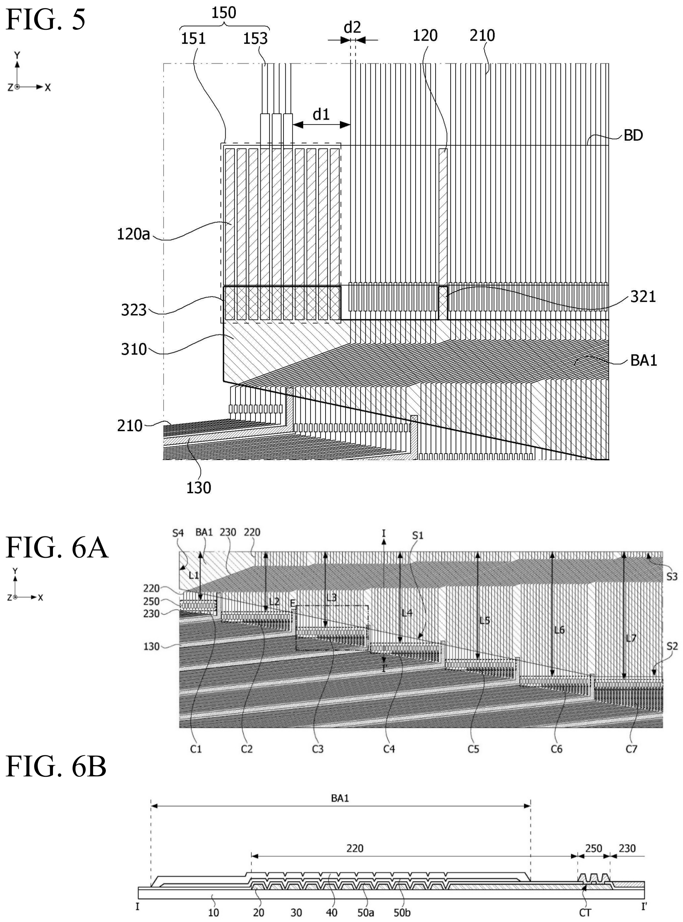

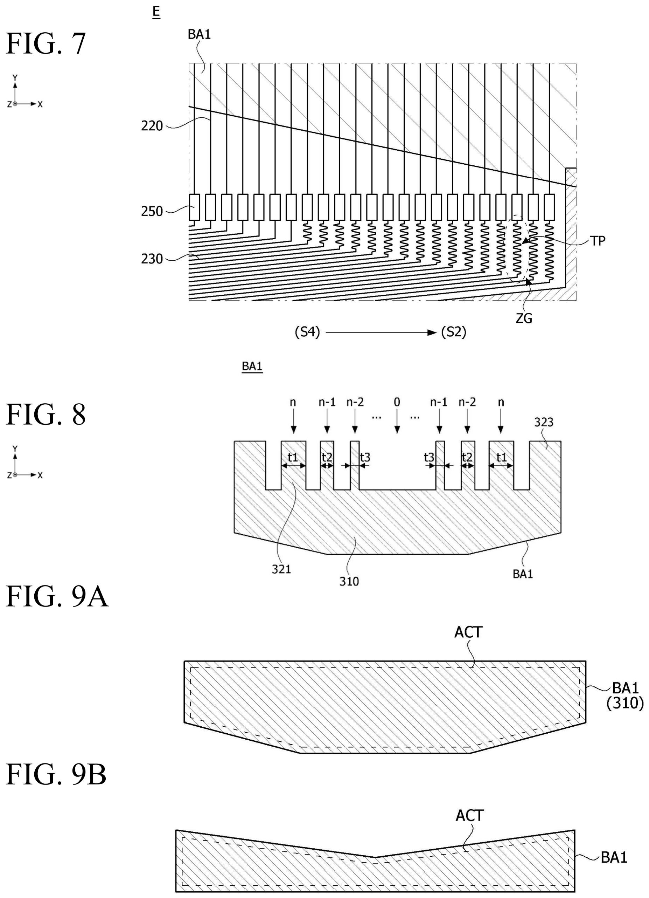

FIG. 4 is an enlarged plan view of an area A in FIG. 1. FIG. 5 is an enlarged plan view of an area B in FIG. 4. FIG. 6A is a view illustrating connection portion of a second link part of an embodiment, and FIG. 6B is a cross-sectional view along the lines I-I' of FIG. 6A. FIG. 7 is an enlarged plan view of an area E in FIG. 6A.

Referring to FIGS. 4 to 7, the display panel of an embodiment of the disclosure may include a bonding portion BD for bonding various wires to the circuit film COF, a first-first link wire 120, a first link part 110 including a second link part 210, a dummy link part 150, and the electrode pattern EP, which are bonded to the bonding portion BD, and the first bar BA1 connected to the first link part 110 and the dummy link part 150.

The bonding portion BD may be a component for attaching various wires to the circuit film COF. The first-first link wire 120, the second link part 210, the dummy link part 150, and the electrode pattern EP may be attached to the bonding portion BD. Since various wires are attached to the circuit film COF through the bonding portion BD, the voltage supplied from an external circuit (or external power source, not shown) disposed outside the display panel may be controlled. Here, the area of the bonding portion BD is not limited to that shown.

A plurality of first link parts 110 may be provided. A plurality of first link parts 110 may be arranged between the dummy link parts 150 placed on the sides of the first bar BA1 in the horizontal direction X. The dummy link parts 150 may be placed at opposing outer sides of the first bar BA1. The plurality of first link parts 110 may be supplied with the same voltage as the dummy link parts 150. For example, a driving voltage may be supplied to the first link part 110 and the dummy link parts 150.

The first link part 110 may include a plurality of first-first link wire 120, and a plurality of first-second link wire 130. The plurality of first-first link wires 120 and the plurality of first-second link wires 130 each may be connected to the first bar BA1.

A plurality of first-first link wires 120 may be provided. The plurality of first-first link wires 120 are spaced apart from each other and may be connected to the circuit film COF and the first bar BA1. Such first-first link wire 120 may transmit signals supplied from the circuit film COF to the first bar BA1.

A plurality of first-second link wires 130 may be provided. A plurality of first-second link wires 130 are spaced apart from each other and may be placed between the first bar BA1 and the display area AA. The first-second link wire 130 may have one end connected to the first bar BA1 and the other end connected to a signal line or a second bar BA2 disposed in the display area AA. Such first-second link wire 130 may transmit signals supplied from the first bar BA1 to the display area AA.

The dummy link part 150 may be disposed on the sides of the first bar BA1 in the horizontal direction X. The dummy link part 150 may include a dummy pad 151 and a dummy pin 153. For example, the driving voltage may be supplied to the dummy link part 150.

The dummy pad 151 may include a plurality of dummy link wires 120a. The plurality of dummy link wires 120a may be disposed side-by-side in the horizontal direction X. Each of the dummy link wires 120a may have the same form as each of the first-first link wires 120. For example, the dummy pad 151 may include at least two dummy link wires 120a. However, the number of dummy link wires 120a of the dummy pad 151 in an embodiment is not limited.

The dummy pad 151 may provide a separation distance between its adjacent second link part 210 and the dummy pin 153. The dummy pad 151 may be connected to the dummy pin 153 on one side, to the first bar BA1 on the other side, and to the circuit film COF between the two sides. Accordingly, the dummy pad 151 may transfer the voltage supplied from the dummy pin 153 to the first bar BA1 through the circuit film COF.

The dummy pin 153 may be a wire connected to the outside of the display panel. In other words, the dummy pin 153 is exposed to the outside and thus may be vulnerable to environmental effects. For example, the dummy pin 153 may be connected to a power supply circuit (or external supply, not shown) disposed on the outside of the circuit film COF.

The dummy pin 153 may be connected to some of the plurality of dummy link wires 120a of the dummy pad 151 to have a predetermined minimum distance, namely the first distance d1 from the second link part 210 disposed closest to respective dummy link part 150. In the case as shown in FIG. 5, the minimum distance may be the distance between the rightmost dummy pin 153 and the second link part 210. The first distance d1 may be at least greater than the second distance d2 between adjacent second link parts 210. Further, the first distance d1 may be at least greater than the distance between the first-first link wire 120 and adjacent second link part 210. Accordingly, even if electrolytic corrosion occurs in the dummy pin 153 and the second link part 210 exposed to the outside of the display panel, the two wires may not be short-circuited.

For example, the dummy pin 153 and the second link part 210 may be wires with significant potential differences. For example, from an external circuit, the dummy pin 153 may be supplied with a driving voltage that is a high-potential voltage, and the second link part 210 may be supplied with a data voltage or reference voltage that is lower than the driving voltage. In this case, since the dummy pin 153 and the second link part 210 are spaced apart from each other with the first distance d1, a short circuit due to the electrolytic corrosion may not occur. In other words, the first distance d1 may be set to prevent a short circuit from occurring due to the electrolytic corrosion between the dummy pin 153 and the second link part 210.

The dummy pin 153 may be at least connected to a dummy link wire 120a that is positioned father from the second link part 210 than the dummy link wire 120a closest to the second link part 210. For example, if three dummy pins 153 and ten dummy link wires 120a are provided, the three dummy pins 153 may be connected to the fourth, fifth, and sixth dummy link wires 120a among the ten dummy link wires, respectively. However, the connection configuration of the dummy pin 153 and the dummy link wire 120a is not limited thereto.

The first bar BA1 may be connected to a plurality of first link parts 110 and a plurality of dummy link parts 150. For example, the first bar BA1 may be an area adjacent to the bonding portion BD, and may be connected to a plurality of first-first link wires 120 and a plurality of dummy pads 151. For example, the first bar BA1 may be an area adjacent to the display area AA and may be connected to a plurality of first-second link wires 130.

The first bar BA1 may include a bar pattern 310, a first bridge 321, and a second bridge 323. The bar pattern 310, the first bridge 321, and the second bridge 323 may be integrally formed.

The bar pattern 310 may be connected to the first-second link wire 130 located between it and the display area AA. The bar pattern 310 shown in FIGS. 4 to 7 may have a wider width at the center than at the sides in the horizontal direction X. However, the bar pattern 310 illustrated in FIGS. 4 and 5 may also be in the form of the first bar BA1 illustrated in FIG. 3B.

The first and second bridges 321 and 323 may be areas that protrude from the bar pattern 310 in the direction of the circuit film COF. The first and second bridges 321 and 323 may be connected respectively to the first-first link wire 120 and the dummy link wire 120a connected to the circuit film COF.

A plurality of first bridges 321 may be provided. The plurality of first bridges 321 may be arranged at intervals between the second bridges 323. The first bridge 321 may be connected to the first-first link wire 120.

The second bridge 323 may be located on the sides of the bar pattern 310 in the horizontal direction X. The second bridge 323 may be connected to the dummy link wires 120a. The second bridge 323 may have a predetermined width in the horizontal direction X of the first bar BA1 for connection to the plurality of dummy link wires 120a. The width of the second bridge 323 may be at least greater than the width of the first bridge 321.

As such, the first bar BA1 may reduce the current density of the plurality of link wires. Accordingly, the first bar BA1 may have a heat dissipation effect on the heat generated due to the concentration of the plurality of link wire connected to the first bar BA1 in a limited space.

Additionally, when a plurality of first link parts 110 and dummy link parts 150 are supplied with a driving voltage that is a high-potential voltage, they may generate increased heat compared to other signal wires. In this case, the first bar BA1 is connected to a plurality of first link parts 110 and dummy link parts 150, thereby reducing heat generation in the signal wires supplied with the high-potential voltage.

A plurality of second link parts 210 may be provided. The plurality of second link parts 210 may be arranged between the dummy link part 150 and the first link part 110, as well as between the plurality of first link parts 110. Furthermore, a plurality of second link parts 210 may overlap with the first bar BA1 in the thickness direction Z.

For example, a plurality of second link parts 210 may be connected to an external circuit (not shown) disposed outside the circuit film COF. The plurality of second link parts 210 may extend from the external circuit and may be connected to the circuit film COF. The plurality of second link parts 210 may be connected to various signal wires arranged in the display area AA through the first bar BA1. For example, the plurality of second link parts 210 may include wires supplied with a reference voltage and wires supplied with a data voltage.

Referring to FIGS. 6A and 6B, each of the plurality of second link parts 210 may include a second-first link wire 220, a second-second link wire 230, and a connection portion 250 connecting the second-first and the second-second link wires 220 and 230.

The second-first link wire 220 may refer to a wire reaching the connection portion 250 from the pad part PAD. The second-first link wire 220 may have an overlapping area with the first bar BA1. Any one of the second-first link wires 220 may pass through the third side S3 of the first bar BA1, through the bar pattern 310 of the first bar BA1, and then through the first side S1 or the second side S2. The second-second link wire 230 may refer to a wire extending from the connection portion 250 toward the display area AA.

The second-first and the second-second link wires 220 and 230 may be connected to the connection portion 250. The connection portion 250 may be spaced apart from the first and second sides S1 and S2 of the first bar BA1 in the vertical direction Y.

Referring to FIG. 6B, the second-first link wire 220 and the second-second link wire 230 may be formed on different layers, and the second-second link wire 230 and the first bar BA1 may be formed on the same layer. The second-first and the second-second link wires 220 and 230 may be in contact with each other through contact holes CT at the connection portion 250 with the first insulating layer 50a interposed therebetween.

Here, since the first bar BA1 and the second link part 210 must not be electrically connected, the first bar BA1 may overlap the second-first link wire 220, but must not overlap the second-second link wire 230. Accordingly, the connection portions 250 may be located between the first bar BA1 and the display area AA, such that it does not overlap the first bar BA1.

The connection portions 250 may be disposed adjacent to the first bar BA1, between the first bar BA1 and the display area AA. For example, the connection portions 250 may be arranged side-by-side in the horizontal direction X between the first-second link wires 130.

For example, the connection portions 250 arranged at the fourth side S4 may form a first unit region C1. The connection portions 250 located between the first-second link wires 130 arranged along the first side S1 from the fourth side S4 may sequentially form a second unit region C2, a third unit region C3, a fourth unit region C4, a fifth unit region C5, and a sixth unit region C6. The connection portions 250 located at the second side S2 may form a seventh unit region C7.

The first to seventh unit regions C1, C2, C3, C4, C5, C6, and C7 may be arranged along the first side S1 and the second side S2. For example, the first to seventh unit regions C1, C2, C3, C4, C5, C6, and C7 may be arranged in a stepped configuration along the first side S1 and the second side S2. Here, the stepped configuration may refer to a form in which the first to seventh unit regions C1, C2, C3, C4, C5, C6, and C7 are arranged side-by-side in the horizontal direction X while being positioned so as not to overlap in the vertical direction Y.

The numbers of connection portions 250 arranged in each of the first to seventh unit regions C1, C2, C3, C4, C5, C6, and C7 may be different. That is, as the first bar BA1 has a wider thickness toward the center in the horizontal direction X, each of the first to seventh unit regions C1, C2, C3, C4, C5, C6, and C7 arranged in a diagonal direction may have a different number of connection portions 250. However, the number of connection portions included in the unit regions of an embodiment of the disclosure is not limited thereto.

Further, each of the first to seventh unit regions C1, C2, C3, C4, C5, C6, and C7 may have a different separation distance from the third side S3 of the first bar BA1. For example, the first unit region C1 may have a first separation distance L1 from the third side S3 of the first bar BA1, the second unit region C2 may have a second separation distance L2 greater than the first separation distance L1 from the third side S3 of the first bar BA1, the third unit region C3 may have a third separation distance L3 greater than the second separation distance L2 from the third side S3 of the first bar BA1, the fourth unit region C4 may have a fourth separation distance L4 greater than the third separation distance L3 from the third side S3 of the first bar BA1, the fifth unit region C5 may have a fifth separation distance L5 greater than the fourth separation distance L4 from the third side S3 of the first bar BA1, the sixth unit region C6 may have a sixth separation distance L6 greater than the fifth separation distance L5 from the third side S3 of the first bar BA1, and the seventh unit region C7 may have a seventh separation distance L7 greater than the sixth separation distance L6 from the third side S3 of the first bar BA1.

Referring to FIG. 7, the second-second link wires 230 may have a zigzag region ZG corresponding to some of the connection portions 250. The second-second link wire 230 may have multiple turning points TP in the zigzag region ZG. The second-second link wire 230 may be formed in a zigzag shape by changing direction at a plurality of turning points TP.

The plurality of signal wires reaching the display area AA from the circuit film COF may have longer paths the farther they are positioned from the center in the horizontal direction X. Accordingly, the second-second link wire 230 of an embodiment of the disclosure may include the zigzag region ZG to prevent signal delays due to path differences.

The number of second-second link wires 230 including the zigzag region ZG may be different for each of the unit regions C1, C2, C3, C4, C5, C6, and C7. Additionally, the turning points TP in the zigzag region ZG may be formed in different numbers for each of the second-second link wires 230 included in a single unit region C1, C2, C3, C4, C5, C6, and C7.

Overall, in each unit region, the zigzag region ZG closer to the center in the horizontal direction X may include more turning points TP. For example, in each of the unit regions C1, C2, C3, C4, C5, C6, and C7, the zigzag region ZG furthest from the center can include the fewest turning points TP, while the zigzag region ZG closest to the center can include the most turning points TP, but the embodiments of this disclosure are not limited thereto. Additionally, the closer to the center in the horizontal direction X, the more zigzag regions ZG are included in each of the unit regions C1, C2, C3, C4, C5, C6, and C7. For example, the unit region C1 furthest from the center may include the fewest zigzag regions ZG, while the unit region C7 closest to the center may include the most zigzag regions ZG, but the embodiments of this disclosure are not limited thereto.

It should be noted that the features on the left side of the structure in FIG. 4 described above in conjunction with FIGs. 5, 6A and 7 also apply to its right side.

The electrode pattern EP may be spaced apart from the first bar BA1 and connected to the circuit film COF. For example, a common voltage may be supplied to the electrode pattern EP.

FIG. 8 is a diagram illustrating the first bar BA1 of an embodiment.

Referring to FIG. 8, the first bar BA1 of an embodiment may include a plurality of first bridges 321 having different widths.

The plurality of first bridges 321 of an embodiment may have a wider width as they move from the center of the first bar BA1 toward the sides in the horizontal direction X. For example, the (n)th first bridges positioned at the outmost sides in the horizontal direction X may have a first width t1, the (n-1)th first bridges positioned inward therefrom may have a second width t2, and the (n-2)th first bridges positioned further inward may have a third width t3. Here, the first width t1 may be greater than the second width t2, and the second width t2 may be greater than the third width t3.

Accordingly, the plurality of first bridges 321 of the first bar BA1 of the display panel of an embodiment of the disclosure may be formed with a wider width toward the sides in the horizontal direction X, thereby achieving the effect of distributing the heat from the central portion to the sides. In other words, the display panels of an embodiment of the disclosure may have the effect of reducing heat generation.

Furthermore, the display panel of an embodiment of the disclosure may have the effect of minimizing heat generation by forming the shape of the bar pattern 310 of the first bar BA1 as shown in FIG. 3A or FIG. 3B.

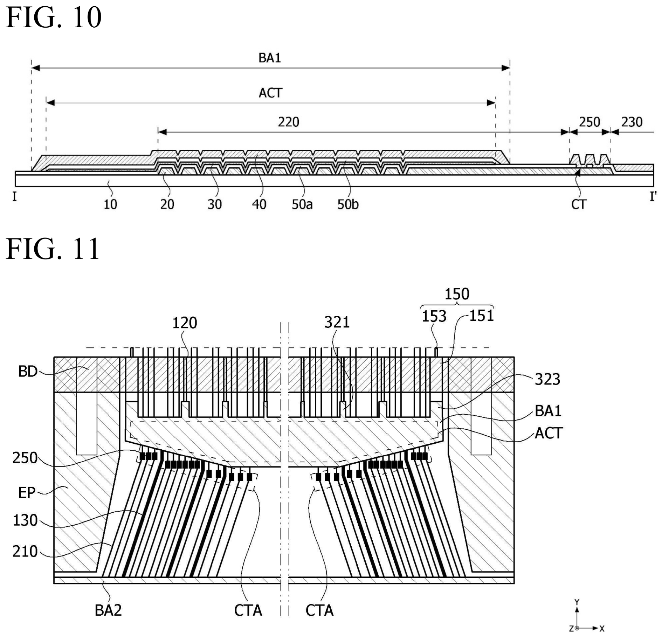

FIGS. 9A and 9B are diagrams illustrating semiconductor patterns corresponding to the shape of the first bar of various embodiments. FIG. 10 is a cross-sectional view along lines I-I' of FIG. 6A including the semiconductor pattern.

Referring to FIGS. 9A and 9B, the display panel of an embodiment of the disclosure may include a semiconductor pattern ACT corresponding to the shape of the first bar BA1. Specifically, the semiconductor pattern ACT may be formed in a form that corresponds to the bar pattern 310 of the first bar BA1.

Referring to FIG. 10, the display panel of an embodiment of the disclosure may include a substrate 10, a first metal layer 20 disposed on the substrate 10, a first insulating layer 50a disposed on the first metal layer 20, a semiconductor layer 30 disposed on the first insulating layer 50a, a second insulating layer 50b disposed on the semiconductor layer 30, and a second metal layer 40 disposed on the second insulating layer 50b.

Here, the semiconductor pattern ACT is the semiconductor layer 30, the second-first link wire 220 is the first metal layer 20, and the first bar BA1 is the second metal layer 40. Accordingly, the semiconductor layer 30 may be disposed in an overlapping region between the two metal layers 20 and 40. In other words, the semiconductor pattern ACT may overlap the first bar BA1 and the second link part 210. The semiconductor pattern ACT, acting as a type of insulating film, may reduce the vertical short (in thickness direction, Z) due to foreign substance in the overlapping region of the first bar BA1 and the second link part 210.

For example, the semiconductor layer 30, or semiconductor pattern ACT, may be formed of a semiconductor material. For example, the semiconductor layer 30 may include any one of Si (silicon), Poly-Si (polysilicon), IGZO (Indium Gallium Zinc Oxide), and GaN (gallium nitride).

FIG. 11 is a schematic plan view of a display panel to which embodiments of the disclosure are applied.

Referring to FIG. 11, the display panel of an embodiment of the disclosure may include a first bar BA1 including a plurality of first and second bridges 321 and 323, a first-first link wire 120 connected to the first bridge 321, dummy link parts 150 (including dummy pads 151 and dummy pins 153) connected to the second bridge 323, a second bar BA2 and a second link part 210 connected to the first bar BA1 and the second bar BA2 and disposed between the first bar BA1 and the second bar BA2.

Here, the first bar BA1 may have a wider width (in the vertical direction Y) toward the center in the horizontal direction X. The first bridges 321 may have a wider width (in the horizontal direction X) as they moves from the center of the first bar BA1 toward the sides in the horizontal direction X. The dummy link part 150 may have a predetermined separation distance from its neighboring second link part 210. The connection portion 250 may be arranged in an optimal form CTA according to the shape of the first bar BA1. The display panel may include a semiconductor pattern ACT overlapping the first bar BA1 and the second link part 210.

Accordingly, the display panel of an embodiment of the disclosure may have the effect of minimizing the heat generation in the pad part by distributing the heat generated by the concentration of wires in a limited space through the shape of the first bar BA1, and the shape of the first bridges 321.

Furthermore, the display panel of an embodiment of the disclosure may include a dummy link part 150, thereby achieving the effect of preventing short circuiting between the wires.

Additionally, the display panel of an embodiment of the disclosure may stably form the first bar BA1 by including a semiconductor pattern ACT, thereby preventing short circuits in the vertical direction.

Accordingly, the embodiments disclosed in the disclosure are not intended to limit the technical spirit of the disclosure, but intended to describe the same, and the scope of the technical spirit of the disclosure is not limited by these embodiments.

Accordingly, the embodiments disclosed in the disclosure are not intended to limit the technical spirit of the disclosure but illustrate it, and the scope of the technical spirit of the disclosure is not limited by these embodiments.

Accordingly, the above-described embodiments should be understood as exemplary in all aspects and not restrictive.

The scope of the disclosure should be defined by the claims, and it should be interpreted that all technical ideas within the equivalent range are included in the scope of the disclosure.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A display panel comprising:
a circuit film (COF);
a plurality of first link parts (110) electrically connected to the circuit film (COF); and
a first bar (BA1) including a plurality of first bridges (321) arranged at intervals along a first direction (X), each having a width in the first direction (X) and connected to a respective one of the plurality of first link parts (110), the first bar (BA) having opposite ends and a center between the opposite ends,
wherein the widths of the plurality of first bridges (321) increase from the center of the first bar (BA1) toward the opposite sides of the first bar (BA) in the first direction (X).

2. The display panel of claim 1, wherein the wherein the first bar (BA1) has either a width that is greater at a center than at opposite sides thereof in the first direction (X), or a width that is greater at the opposite sides than at the center in the first direction (X).

3. The display panel of claim 1 or 2, further comprising:
dummy link parts (150) connected respectively to the sides of the first bar (BA1) in the first direction (X); and
a plurality of second link parts (210) disposed between the dummy link parts (150),
wherein each of the dummy link parts (150) includes dummy pins (153) connected to an external circuit disposed outside the circuit film (COF), and
wherein a minimum distance between the dummy pins (153) and the second link part (210) that is closest to the respective dummy link part (150) is a first distance (d1),
there is a second distance (d2) between adjacent second link parts (210), and
the first distance (d1) is greater than the second distance (d2).

4. The display panel of claim 3, wherein each of the dummy link parts (150) includes dummy pads (151) connected to the first bar (BA1) on one end and connected to the dummy pins (153) on the other end, each of the dummy pads (151) includes a plurality of dummy link wires (120a), and the dummy pins (153) are connected to some of the dummy link wires (120a).

5. The display panel of any one of the preceding claims, wherein the first bar (BA1) further includes second bridges (323), on each of the outer sides of the first bar (BA1) in the first direction (X) and each of the second bridges (323) has a wider width than each of the first bridges (321).

6. The display panel of any one of the preceding claims 3-5, wherein the first link parts (110) are configured to be supplied with a driving voltage from the circuit film (COF) and/or the dummy link parts (150) are configured to be supplied with a driving voltage from the external circuit of the circuit film (COF), and/or the second link parts (120) are supplied with a reference voltage or a data voltage from the external circuit of the circuit film (COF.

7. The display panel of any one of the preceding claims, wherein the first bar (BA1) includes a bar pattern,
the first bridges (321) projecting from the bar pattern (310) in a second direction (Y) transverse to the first direction (X), and the bar pattern (310) includes:
a second side (S2) disposed in the first direction (X);
first sides (S1) bent at both ends of the second side (S2);
fourth sides (S3) bent from the first sides (S1); and
fourth side (S4) respectively connected to the third sides (S3, and
wherein the distance between the third side (S3) and each of the first sides (S1) increase respectively from the sides toward the center in the first direction (X).

8. The display panel of any one of the preceding claims, further comprising:
a plurality of second link parts (210) disposed between the first link parts (110), each of the second link parts (210) includes:
connection portions (250) spaced apart from the first bar (BA1); and
a second-first link wire (220) and a second-second link wire (230) connected via the connection portions (250), wherein the connection portions (250) form unit regions (C1-C7) between the first link parts (110), the connection portions (250) disposed in the unit regions (C1-C7) are arranged side-by-side in the first direction (X).

9. The display panel of claim 8, wherein the unit regions (C1-C7) disposed between the first link parts (110) are arranged in a stepped configuration along the first side (S1) of the first bar (BA1) and/or the unit regions (C1-C7) disposed between the first link parts (110) include a different number of connection portions (C1-C7).

10. The display panel of claim 8 or 9, wherein the second-second link wire (230) includes a zigzag region (ZG), and the number of zigzag regions (ZG) included in the unit regions (C1-C7) increases from the sides toward the center of the first bar (BA1) in the first direction (X); and/or
a zigzag region is bent by changing direction based on a turning point, preferably the number of turning points included in the zigzag regions in each of the unit regions (C1-C7) increases from the sides toward the center in the first direction (X).

11. The display panel of any one of the preceding claims 1 or 2, wherein the first bar (BA1) has a width in a second direction (Y) transverse to the first direction (X), wherein the width that increases from the center toward the sides in the first direction.

12. The display panel of any one of the preceding claims, wherein the first bar (BA1) has a plane extending in the first direction (X) and a second direction (Y) transverse to the first direction (X), and a cross-section in a third direction (Z) perpendicular to the plane, wherein the display panel (100) further comprises:
a plurality of second link parts (210) disposed between the first link parts (110) and having an overlapping region overlapping with the first bar (BA1) in the third direction (Z); and
a semiconductor pattern disposed in the overlapping region and between the first bar and the second link parts.

13. The display panel of any one of the preceding claims, wherein the first bar (BA1) further includes a bar pattern (310) and second bridges (323), wherein the bar pattern (310), the first bridges (321), and the second bridges (323) are integrally formed.

14. The display panel of claim 13, wherein the first bridges projecting in the second direction (Y) and are respectively connected to the second link parts (210); and the second bridges (323) projecting in the second direction (Y) and are respectively connected to the dummy link parts (150), wherein each of the first and the second bridges (321, 323) has a width in the first direction (X), wherein each of the second bridges (323) has a wider width than each of the first bridges (321), preferably the widths of the first bridges (321) increase from a center of the first bar (BA1) toward opposite sides of the first bar (BA1) in the first direction (X).

15. A display device, comprising the display panel as claimed in any one of the preceding claims.
